# DEMANDE DE BREVET EUROPEEN

(11) **EP 0 980 198 A1**
(43) Date de publication de la demande: **16.02.2000**
(21) Numéro de dépôt: 99401995.8
(22) Date de dépôt: 05.08.1999
(51) Int. Cl.: H05K 3/34, H01L 21/48

(54) **Outillage amovible pour la réalisation de bossages, conducteurs électriques, sur des composants électroniques**

(30) Priorité: 13.08.1998 FR 9810403
(71) Demandeur: BULL S.A., 78430 Louveciennes (FR)
(72) Inventeur: Petit, Claude, 91140 Villebon sur Yvette (FR); Saint-Martin, Xavier, 78340 Les Clayes (FR)

(57) **Abrégé**

Outillage amovible pour la réalisation de bossages (10i) sur des plots conducteurs (4i) de composants électroniques (2) à partir de billes (3i), conducteurs électriques, déposées et soudées sur les plots récepteurs (4i), comportant une grille (1) comportant un nombre déterminé d'orifices (5i) destinés à être positionnés sur les plots récepteurs (4i), caractérisé en ce que les orifices (5i) destinés à recevoir les billes (3i) sont dimensionnés pour:
- ne recevoir qu'une seule bille (3i) par plot récepteur (4i) ;
- guider la bille (3i) vers son plot récepteur (4i) ; et
- maintenir la bille (3i) en position sur son plot récepteur (4i) au début du soudage de manière que les parois internes de l'orifice (5i) ne touchent pas la bille (3i) pendant et après déformation de la bille (3i) due à la fusion de la bille (3i).

## Description

La présente invention se rapporte au domaine de la connectique et plus précisément à la connectique des boîtiers sur des cartes électroniques.

Elle concerne plus particulièrement un outillage amovible pour la réalisation de bossages, conducteurs électriques, sur des plots conducteurs de composants électroniques à partir de billes, conducteurs électriques, déposées et soudées sur les plots récepteurs.

La partie essentielle de l'outillage est une grille comportant un nombre déterminé d'orifices 5i destinés à être positionnés sur les plots récepteurs des composants.

Les composants sont notamment du type BGA, abréviations anglo-saxonnes pour "Ball Grid Array".

Ces bossages, ou "bumps" en terminologie anglo-saxonne, sont destinés à recevoir à leur tour des plots de connexion de cartes ou de composants avec lesquels ils assurent une continuité électrique.

Des bossages sont actuellement réalisés soit sur puces nues soit sur composants électroniques destinés à être montés sur une carte de circuit imprimé.

Dans le cas de puces nues, la formation de bossages est réalisée, par exemple, par des machines de microcâblage, par un dépôt chimique ou électrochimique, et par billage.

Dans le cas de composants électroniques, deux types de soudure sont utilisés : un premier type concerne des soudures qui refondront pendant le montage sur carte, et le deuxième type concerne des soudures qui ne refondront pas, parce que leur température de fusion a été choisie assez haute.

La présente invention se rapporte à la réalisation de bossages réalisés à partir d'une soudure du premier type.

Pour réaliser des bossages d'alliage de soudure, il est connu d'utiliser des équipements automatiques qui déposent des billes d'alliage sur les plots d'un composant à câbler. Les billes sont ensuite soudées par apport de chaleur sur leurs plots respectifs.

Les billes doivent être maintenues en place entre le moment où elles sont déposées sur leurs plots respectifs et celui où elles sont soudées pour former les bossages.

Pour cela, soit les plots comportent des cavités permettant de centrer les billes, soit ils sont préalablement recouverts d'un matériau visqueux, par exemple du flux, immobilisant les billes.

Les inconvénients de tels équipements viennent essentiellement des coûts de développement de dispositifs de placement des billes sur leurs plots et de maintien des billes entre le moment du placement et celui du chauffage.

Le fait notamment de prévoir des cavités au niveau de chaque plot entraîne des contraintes de conception importantes.

L'invention a notamment pour but de pallier ces inconvénients.

A cet effet, l'invention a pour premier objet un outillage amovible pour la réalisation de bossages sur des plots récepteurs de composants électroniques à partir de billes, conducteurs électriques, déposées et soudées sur les plots récepteurs, définissant une grille comportant un nombre déterminé d'orifices destinés à être positionnés sur les plots récepteurs.

L'outillage selon l'invention est caractérisé en ce que les orifices destinés à recevoir les billes sont dimensionnés pour:
- ne recevoir qu'une seule bille par plot récepteur ;
- guider la bille vers son plot récepteur ; et
- maintenir la bille en position sur son plot récepteur au début du soudage de manière que les parois internes de l'orifice ne touchent pas la bille pendant et après déformation de la bille due à la fusion de la bille.

Selon une caractéristique chaque orifice comporte :
- une première partie tubulaire recevant la bille par une première extrémité dont l'ouverture est dimensionnée pour ne laisser passer qu'une seule bille, et guidant la bille jusqu'à une deuxième extrémité distante de la première dont l'ouverture est similaire à celle de la première extrémité ; et
- une deuxième partie prolongeant la première partie, par l'ouverture de sa deuxième extrémité, en s'évasant pour déboucher au droit du plot récepteur ; la hauteur et l'amplitude de l'évasement étant déterminées en fonction du diamètre de la bille et de la température de fusion de la bille pour maintenir la bille au début du soudage sans altérer la déformation naturelle de la bille pendant et après la déformation.

Selon une autre caractéristique, la première partie tubulaire définit un cylindrique de révolution.

Selon une autre caractéristique, la deuxième partie définit un tronc de cône de révolution.

Selon une autre caractéristique, les orifices ont une forme géométrique de révolution.

Selon une autre caractéristique, les parois internes des orifices sont traitées pour que les billes n'adhèrent pas aux parois pendant leur fusion.

L'invention a pour deuxième objet un procédé de mise en oeuvre de l'outillage introduit ci-dessus.

Le but de l'invention est de proposer un outillage simple et peu coûteux pouvant être appliqué à de petites et moyennes séries de composant s à câbler et qui n'intervient pas dans la déformation naturelle des billes lors du soudage.

D'autres avantages et caractéristiques de la présente invention apparaîtront à la lecture de la description qui suit faite en référence aux figures annexées qui représentent:
- la figure 1, un mode de réalisation d'une grille d'un outillage selon l'invention, en vue de dessus correspondant à la face supérieure de la grille recevant les billes ;
- la figure 2, un orifice suivant une vue en coupe partielle de la grille selon l'invention ;
- la figure 3, l'orifice de la figure 2 disposé sur le plot récepteur d'un composant et recevant une bille par son ouverture supérieure ; et
- la figure 4, la bille contenue à l'intérieur de l'orifice, avant et après le soudage de la bille sur son plot récepteur.

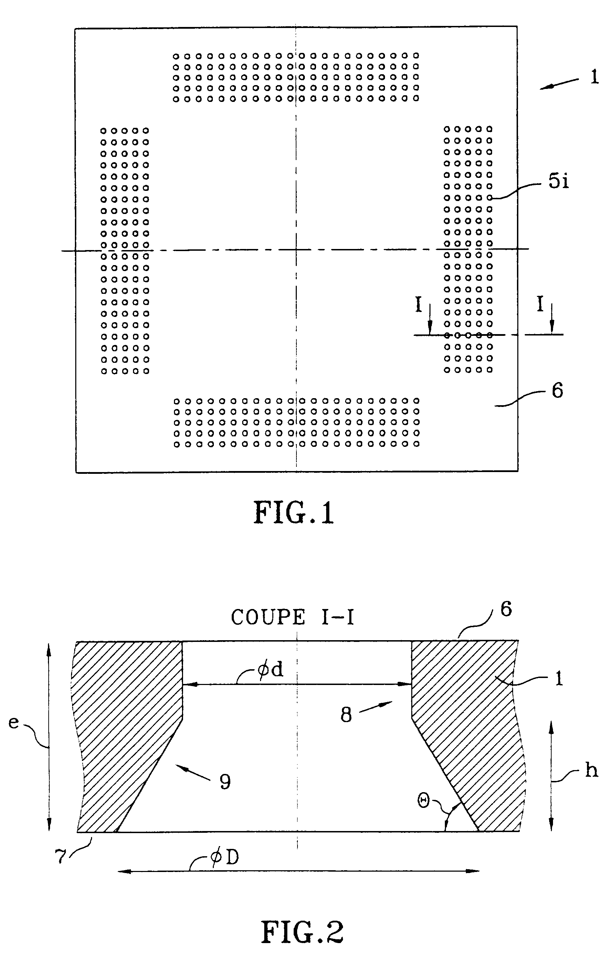

Sur les figures, les éléments homologues sont désignés par la même référence et les figures 2 à 4 sont respectivement à l'échelle.

La figure 1 illustre schématiquement en vue de dessus, un mode de réalisation d'une grille 1 d'un outillage selon l'invention, destinée à être disposée sur la face d'un composant 2 à équiper de billes 3i, conducteurs électriques, pour former des bossages sur des plots récepteurs 4i du composant 2.

L'outillage reste positionné sur le composant 2 pendant l'opération de soudage des billes 3i sur leurs plots récepteurs 4i respectifs.

Dans ce mode de réalisation, la grille 1 est carrée et est réalisée par exemple en aluminium AU4G.

Elle comporte une pluralité d'orifices 5i dont la répartition sur la grille 1 est déterminée pour que les orifices 5i débouchent respectivement au droit des plots récepteurs 4i du composant 2.

Les orifices 5i sont dimensionnés et répartis sur la grille 1 pour assurer les trois fonctions principales suivantes :
- ils ne peuvent recevoir qu'une bille 3i par plot récepteur 4i ;
- ils maintiennent les billes 3i en position sur leurs plots 4i ;
- pendant le chauffage, les parois internes de l'orifice 5i ne doivent pas être en contact avec la bille 3i en fusion de telle manière que l'outillage n'intervienne pas sur la forme finale de la bille 3i ; forme correspondant à celle qu'elle aurait en l'absence d'outillage.

Les orifices 5i sont disposés suivant un pas déterminé correspondant au pas des plots récepteur 4i du composant 2 à câbler.

Les plots récepteurs définissent typiquement un carré de 0,6 mm de côté.

Dans le mode de réalisation décrit, 4 fois 110 orifices 5i identiques, de diamètre de l'ordre du mm, sont percés au pas de 1,27 mm avec une tolérance de ± 0,02 sur une première face 6 de la grille 1, correspondant sur la figure 1 et dans le mode opératoire à la face supérieure 6 de la grille 1.

Ces orifices 5i débouchent sur la deuxième face 7 de la grille 1, ou face inférieure 7 qui est la face opposée à la première face 6, destinée à être en regard des plots récepteurs 4i.

Un orifice 5i selon le mode de réalisation décrit, est illustré par la vue en coupe partielle de la figure 2.

L'orifice 5i définit respectivement, en partant de la face supérieure 6 de la grille 1, un cylindre 8 de révolution, creux, dont l'ouverture inférieure débouche en s'évasant vers la face inférieure 7 de la grille 1.

La partie évasée 9 de l'ouverture inférieure définit un tronc de cône de révolution dont la petite base correspond au diamètre Ød du cylindre 8 et la grande base à l'ouverture ØD débouchant sur la face inférieure 7 de la grille 1.

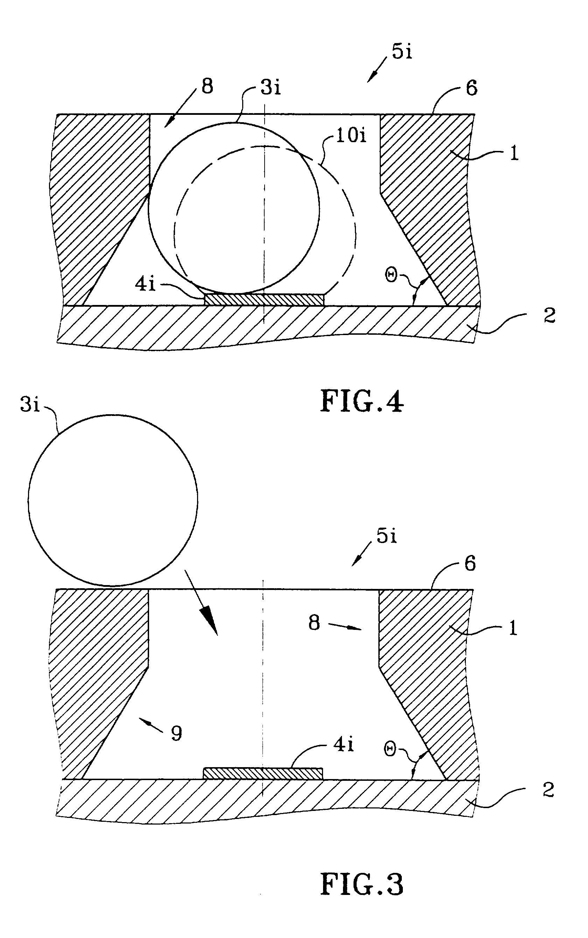

Le cylindre 8 fait office de réceptacle et de guide pour une bille 3i amenée sur la face supérieure 6 de la grille 1 et destinée à être déposée sur le plot récepteur 4i et tel qu'illustré à la figure 3.

La bille 3i ainsi guidée tombe dans l'orifice 5i pour reposer sur le plot récepteur 4i.

La figure 4 illustre la bille 3i reposant sur son plot récepteur 4i et qui dans cette représentation, la plus défavorable, s'appuie contre la paroi interne de l'orifice 5i.

Les dimensions de l'orifice 5i, c'est-à-dire la hauteur e, le diamètre Ød du cylindre 8, la hauteur h, l'ouverture θ et le diamètre ØD de l'évasement 9, sont déterminées en fonction des dimensions de la bille 3i.

Les billes 3i généralement utilisées sont globalement sphériques et ont un diamètre typiquement de l'ordre de 750 µm mais qui peut s'étendre également de 300 µm à plusieurs mm.

Le diamètre Ød du cylindre 8 est déterminé, par exemple, pour être sensiblement supérieur au diamètre de la bille 3i qu'il doit recevoir. Ainsi, un orifice 5i ne peut recevoir qu'une seule bille 3i.

L'ouverture θ et la hauteur h de l'évasement 9, en forme de tronc de cône dans le mode de réalisation décrit, sont déterminées pour que la bille 3i déposée sur le plot récepteur 4i et contenue dans l'orifice 5i, ne soit pas ou plus en contact ni avec la paroi intérieure du cylindre 8, ni avec celle de l'évasement 9, après fusion de la bille 3i.

La bille 3i qui avant fusion présente une forme globalement sphérique, se déforme progressivement quand elle est chauffée et présente, une fois chauffée à une température déterminée T pendant un temps de chauffage t déterminé, une forme se rapprochant globalement d'un tronc de sphère.

A titre d'exemple, pour une bille en alliage Sn-Pb eutectique, on peut appliquer une température de T = 220° C pendant t = 30 s.

Le bossage 10i formé par la bille 3i après déformation est délimité en trait interrompu sur la figure 4.

Le volume du bossage 10i reste identique à celui de la bille 3i en se répartissant différemment dans l'espace.

Dans l'exemple illustré à la figure 4, la hauteur est plus faible et le diamètre est plus grand.

La partie évasée 9 permet en quelque sorte de laisser libre la déformation progressive de la bille 3i pendant sa fusion.

Le cylindre 8 a typiquement un diamètre Ød de l'ordre de 1 mm ± 0,1 et la grande base du tronc de cône à typiquement un diamètre ØD de l'ordre de 1,6 mm ± 0,1.

L'angle θ formé par la grande base et la partie latérale du tronc de cône 9 est typiquement de l'ordre de 60 °.

L'épaisseur de la grille 1, correspondant dans le mode de réalisation décrit à la hauteur e des orifices 5i, est typiquement de l'ordre de 0,8 mm ± 0,1.

La planéité des faces supérieure 6 et inférieure 7 de la grille 1, réalisée par exemple en aluminium, est typiquement de l'ordre de 0,2 mm maximum.

Les faces supérieure 6 et inférieure 7 de la grille 1, ainsi que les parois intérieures des orifices 5i sont traitées, par exemple, par anodisation évitant ainsi que la bille 3i n'adhère aux parois pendant la fusion.

Un procédé de mise en oeuvre de l'outillage selon l'invention comporte schématiquement les étapes successives suivantes consistant :
- à déposer la grille 1 sur la face du composant 2 destinée à être équipée de billes 3i en positionnant la grille 1 pour que les orifices 5i de la grille 1 viennent au droit des plots récepteurs 4i du composant 2 ; la partie évasée 9 des orifices 5i étant en regard des plots récepteurs 4i ;
- à amener les billes 3i dans les orifices 5i, une bille 3i par orifice 5i ;
- à chauffer l'ensemble constitué du composant 2, la grille 1 disposée sur le composant 2, et les billes 3i contenues dans les orifices 5i, pour souder les billes sur les plots récepteurs et former les bossages 10i ; et
- à retirer la grille 1 de la face du composant 2 équipé des bossages 10i.

La présente invention n'est pas limitée au mode de réalisation décrit et englobe tout outillage pour la réalisation de bossages, conducteurs électriques, dont les orifices 5i remplissent la triple fonction telle que définie dans la présente description.

## Revendications

1. Outillage amovible pour la réalisation de bossages (10i) sur des plots récepteurs (4i) de composants électroniques (2) à partir de billes (3i), conducteurs électriques, déposées et soudées sur les plots récepteurs (4i), définissant une grille (1) comportant un nombre déterminé d'orifices (5i) destinés à être positionnés sur les plots récepteurs (4i), caractérisé en ce que les orifices (5i) destinés à recevoir les billes (3i) sont dimensionnés pour:
- ne recevoir qu'une seule bille (3i) par plot récepteur (4i) ;
- guider la bille (3i) vers son plot récepteur (4i) ; et
- maintenir la bille (3i) en position sur son plot récepteur (4i) au début du soudage de manière que les parois internes de l'orifice (5i) ne touchent pas la bille (3i) pendant et après déformation de la bille (3i) due à la fusion de la bille (3i).

2. Outillage selon la revendication 1, caractérisé en ce chaque orifice (5i) comporte :
- une première partie tubulaire (8) recevant la bille (3i) par une première extrémité dont l'ouverture est dimensionnée pour ne laisser passer qu'une seule bille (3i), et guidant la bille (3i) jusqu'à une deuxième extrémité distante de la première dont l'ouverture est similaire à celle de la première extrémité ; et
- une deuxième partie (9) prolongeant la première partie (8), par l'ouverture de sa deuxième extrémité, en s'évasant pour déboucher au droit du plot récepteur (4i) ; la hauteur (h) et l'amplitude (θ) de l'évasement (9) étant déterminées en fonction du diamètre de la bille (3i) et de la température de fusion de la bille (3i) pour maintenir la bille (3i) au début du soudage sans altérer la déformation naturelle de la bille (3i) pendant et après la déformation.

3. Outillage selon la revendications 2, caractérisé en ce que la première partie tubulaire (8) définit un cylindrique de révolution.

4. Outillage selon la revendications 2, caractérisé en ce que la deuxième partie (9) définit un tronc de cône de révolution.

5. Outillage selon l'une quelconque des revendications 1 à 3, caractérisé en ce que les orifices (5i) ont une forme géométrique de révolution.

6. Outillage selon l'une quelconque des revendications 1 à 5, caractérisé en ce que les parois internes des orifices (5i) sont traitées pour que les billes (3i) n'adhèrent pas aux parois pendant leur fusion.

7. Procédé de mise en oeuvre de l'outillage selon l'une quelconque des revendications 1 à 6, caractérisé en ce qu'il consiste :
- à déposer la grille (1) sur la face du composant (2) destinée à être équipée de billes (3i) en positionnant la grille (1) pour que les orifices (5i) de la grille (1) viennent au droit des plots récepteurs (4i) du composant (2) ; la partie évasée (9) des orifices (5i) étant en regard des plots récepteurs (4i) ;
- à amener les billes (3i) dans les orifices (5i), une bille (3i) par orifice (5i) ;
- à chauffer l'ensemble constitué du composant (2), de la grille (1) disposée sur le composant (2), et des billes (3i) contenues dans les orifices (5i) pour souder les billes (3i) sur les plots récepteurs (4i) et former des bossages (10i) ; et
- à retirer la grille (1) de la face du composant (2) équipée des bossages (10i).
